# FASCICULE DE BREVET EUROPEEN

(11) **EP 0 753 941 B1**
(45) Date de publication et mention de la délivrance du brevet: **10.06.1998**
(21) Numéro de dépôt: 96410079.6
(22) Date de dépôt: 09.07.1996
(51) Int. Cl.: H03L 7/197

(54) **Synthétiseur de fréquences**
Frequenzsynthetisierer
Frequency synthesizer

(30) Priorité: 13.07.1995 FR 9508760
(43) Date de publication de la demande: 15.01.1997
(73) Titulaire: SGS-THOMSON MICROELECTRONICS S.A., 94250 Gentilly (FR)
(72) Inventeur: Rodrigues Ramalho, Rui Paulo, c/o SGS-THOMSON, 38926 Crolles (FR)
(74) Mandataire: de Beaumont, Michel

(56) Documents cités:
- EP-A- 0 641 083

## Description

La présente invention concerne un circuit permettant de générer plusieurs horloges à des fréquences différentes. L'invention s'applique plus particulièrement à la réalisation d'un synthétiseur de fréquences propre à être intégré dans un circuit dont le fonctionnement nécessite le recours à plusieurs horloges synchronisées sur une même fréquence de référence.

A titre d'exemple d'application, un synthétiseur selon l'invention peut être intégré dans un décodeur de signaux vidéo et audio compressés selon une norme dite MPEG pour affichage sur un téléviseur. Un tel décodeur requiert plusieurs horloges à destination de différents blocs qu'il comporte et toutes ces horloges doivent être synchronisées sur une fréquence de référence. Par exemple, deux premières horloges sont destinées à un bloc de décodage audio, une troisième horloge est destinée à un bloc de décodage vidéo, une quatrième horloge est destinée à un bloc de génération de l'affichage, etc. Toutes ces horloges présentent des fréquences différentes comprises, par exemple, entre 10 et 100 MHz, et doivent être synchronisées sur une même fréquence de référence, par exemple une fréquence d'échantillonnage des pixels d'images de l'ordre d'une dizaine de MHz.

Classiquement, ces horloges sont générées extérieurement au décodeur MPEG et de manière séparée en affectant une boucle à verrouillage de phase (PLL) à chaque fréquence devant être générée.

La demande de brevet Européen EP-A1-0 641 083 décrit un synthétiseur de fréquences comprenant une boucle à verrouillage de phase dont un oscillateur fournit un nombre impair n de phases de retards croissants d'un signal d'horloge rapide synchronisé sur une fréquence de référence.

La présente invention vise à proposer un synthétiseur de fréquences destiné à délivrer plusieurs signaux d'horloge à partir d'une même boucle à verrouillage de phase délivrant un signal d'horloge rapide synchronisé sur une fréquence de référence.

L'invention vise également à ce que des glissements de phase (jitter) éventuels des différents signaux d'horloges délivrés par rapport à la fréquence rapide délivrée par la PLL soient minimisés.

Pour atteindre ces objets, la présente invention prévoit un synthétiseur de fréquences comprenant une boucle à verrouillage de phase dont un oscillateur fournit un nombre impair n de phases de retards croissants d'un signal d'horloge rapide synchronisé sur une fréquence de référence, chacune desdites n phases étant envoyée sur un même nombre m de diviseurs fractionnels programmables dont les sorties respectives sont envoyées sur m compensateurs de glissement de phase qui délivrent chacun, à partir desdites n phases, un signal d'horloge synchronisé sur ladite fréquence de référence.

Selon un mode de réalisation de la présente invention, chaque diviseur fractionnel comporte un diviseur numérique programmable qui délivre un signal de sortie à une fréquence correspondant, modulo le dénominateur du taux de division fractionnelle, à la fréquence rapide divisée par ledit taux fractionnel, et un accumulateur programmable qui délivre n-1 signaux indicateurs de la position de chaque front montant dudit signal de sortie du diviseur numérique par rapport au quotient, par le nombre n de phases, du dénominateur dudit taux fractionnel.

Selon un mode de réalisation de la présente invention, ledit accumulateur configure ledit diviseur numérique entre un mode de fonctionnement où il divise ladite fréquence rapide par la partie entière dudit taux de division fractionnelle et un mode de fonctionnement où il divise ladite fréquence rapide par ladite partie entière majorée de l'unité, ledit accumulateur étant synchronisé par ledit signal de sortie dudit diviseur numérique.

Selon un mode de réalisation de la présente invention, la partie entière du taux de division fractionnelle est au moins égale à 3.

Selon un mode de réalisation de la présente invention, ledit diviseur numérique est programmé par ladite partie entière, diminuée de l'unité, et reçoit ladite phase utilisée par ledit diviseur fractionnel auquel il est intégré, ledit accumulateur étant programmé par le dénominateur dudit taux de division fractionnelle ainsi que par le reste de la division du numérateur dudit taux fractionnel par ledit dénominateur.

Selon un mode de réalisation de la présente invention, chaque compensateur de glissement de phase comporte un commutateur, à n entrées et une sortie, commandé par n signaux délivrés par n bascules D échantillonnées par ledit signal de sortie dudit diviseur numérique auquel le compensateur est associé, chaque bascule de commande recevant une sortie d'un décodeur logique qui reçoit, en entrée, lesdits n-1 signaux délivrés par ledit accumulateur.

Selon un mode de réalisation de la présente invention, chaque entrée dudit commutateur est relié à une sortie d'une bascule D de déphasage, une première bascule de déphasage étant commandée par la phase de la fréquence rapide qui est utilisée par le diviseur fractionnel associé au compensateur concerné, les autres bascules de déphasage étant commandées, chacune, par une autre desdites phases de la fréquence rapide.

Selon un mode de réalisation de la présente invention, tous les compensateurs de glissement de phase et tous les diviseurs fractionnels que comporte le synthétiseur de fréquences sont de constitution identique, deux étages du synthétiseur se distinguant par la phase que reçoit la première bascule de déphasage de leur compensateur de glissement de phase et/ou par les valeurs introduites pour programmer leur diviseur fractionnel.

Selon un mode de réalisation de la présente invention, ledit oscillateur de la boucle à verrouillage de phase délivre trois phases de la fréquence rapide.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente schématiquement un mode de réalisation d'un synthétiseur de fréquences selon l'invention ;
la figure 2 représente un mode de réalisation d'une boucle à verrouillage de phase du synthétiseur de fréquences représenté à la figure 1 ;
la figure 3 représente, sous forme de schéma-blocs, un mode de réalisation d'un diviseur fractionnel d'un étage du synthétiseur de fréquences tel que représenté à la figure 1 ;
la figure 4 représente un mode de réalisation d'un accumulateur d'un diviseur fractionnel tel que représenté à la figure 3 ;
la figure 5 représente un mode de réalisation d'un diviseur numérique d'un diviseur fractionnel tel que représenté à la figure 3 ;
la figure 6 illustre, sous forme de chronogrammes, le fonctionnement d'un diviseur fractionnel tel que représenté aux figures 3 à 5 ;
la figure 7 représente un mode de réalisation d'un compensateur de glissement de phase d'un étage d'un synthétiseur de fréquences tel que représenté à la figure 1 ; et
la figure 8 illustre, sous forme de chronogrammes, le fonctionnement d'un étage d'un synthétiseur de fréquences selon l'invention tel que représenté à la figure 1.

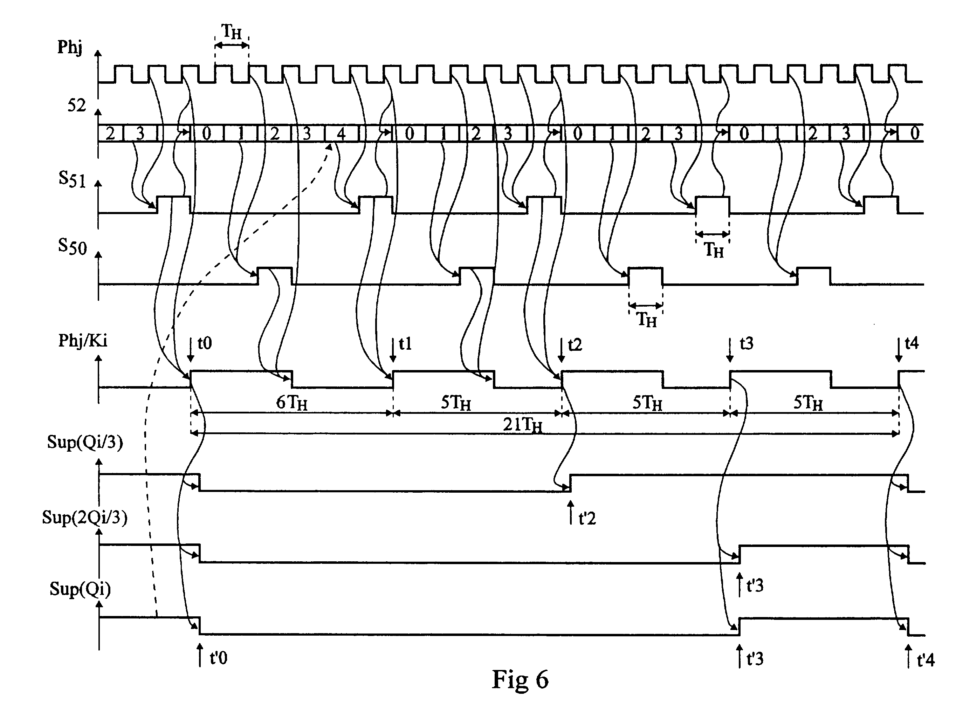

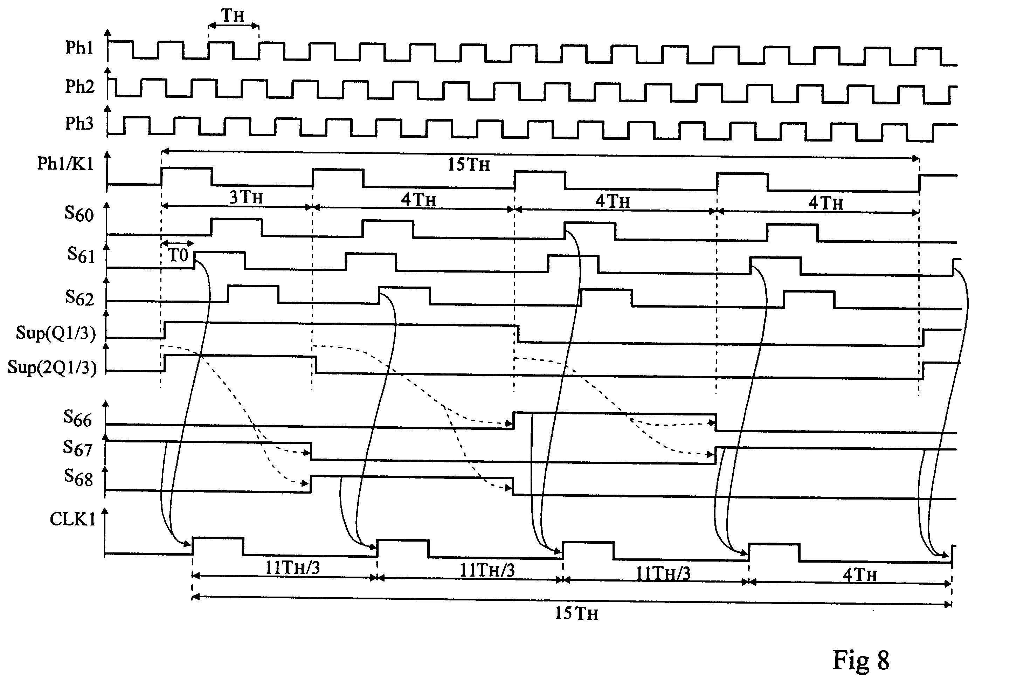

Pour des raisons de clarté, les mêmes éléments ont été désignés par les mêmes références aux différentes figures. Toujours pour des raisons de clarté, les chronogrammes des figures 6 et 8 ne sont pas à l'échelle.

Un synthétiseur de fréquences, selon la présente invention, est destiné à générer plusieurs signaux d'horloge synchronisés sur une même fréquence de référence et à partir d'une même boucle à verrouillage de phase (PLL).

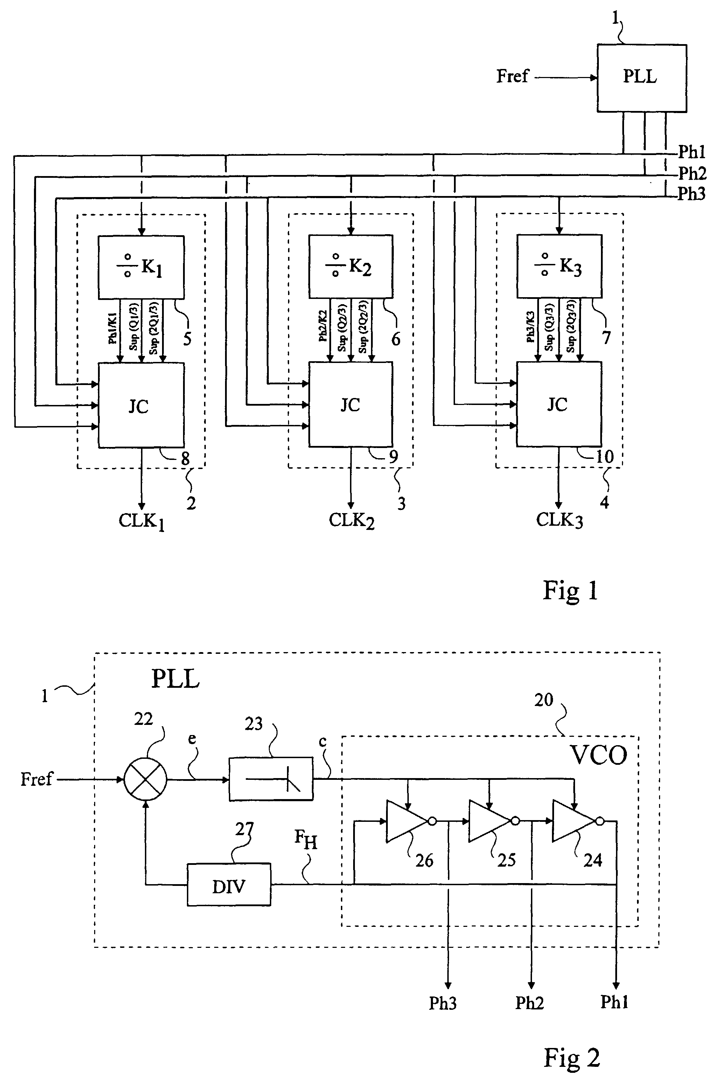

Comme le montre la figure 1, un synthétiseur de fréquences comporte donc une boucle à verrouillage de phase PLL 1 associée à plusieurs étages chargés de générer, chacun, un signal d'horloge de rang i. Dans l'exemple représenté, trois signaux d'horloge CLK₁, CLK₂ et CLK₃ sont générés par trois étages, respectivement 2, 3 et 4, du synthétiseur.

La PLL 1 est, par exemple, une PLL analogique classique dont l'oscillateur est réalisé pour délivrer plusieurs phases de rang j d'un signal d'horloge rapide à une fréquence F_{H}. Dans l'exemple représenté, trois phases Ph₁, Ph₂ et Ph₃ de la fréquence rapide F_{H} sont délivrées par la PLL 1.

Selon l'invention, chaque étage 2, 3 ou 4 est constitué d'un diviseur fractionnel programmable, respectivement 5, 6 ou 7, dont le taux de division, respectivement K₁, K₂ ou K₃, dépend de la fréquence souhaitée pour chaque signal d'horloge CLKᵢ. Chaque diviseur fractionnel 5, 6 ou 7 est associé à un compensateur de glissement de phase (jitter), respectivement 8, 9 ou 10. Chaque compensateur de glissement de phase 8, 9 ou 10 a pour rôle de compenser d'éventuels glissements de phase au niveau de chaque signal à la fréquence Ph₁/K₁, Ph₂/K₂ ou Ph₃/K₃ issu de chaque diviseur fractionnel, respectivement 5, 6 ou 7. En d'autres termes, la fréquence du signal Phⱼ/Kᵢ délivré par un des diviseurs 5, 6 et 7 présente une fluctuation de période aléatoire (jitter) égale à la période T_{H} de la fréquence rapide F_{H}. Le rôle du compensateur 8, 9 ou 10 est alors de resynchroniser le signal Phⱼ/Kᵢ en le décalant de deux tiers, de trois tiers ou de quatre tiers d'une période T_{H} de la fréquence rapide F_{H} délivrée par la PLL 1. Le glissement de phase (jitter) des signaux d'horloge délivrés CLKᵢ est alors, selon l'invention, limité à un tiers de la période T_{H} de la fréquence rapide F_{H}.

Le fonctionnement d'un compensateur de glissement de phase selon l'invention sera mieux compris en relation avec les figures 7 et 8.

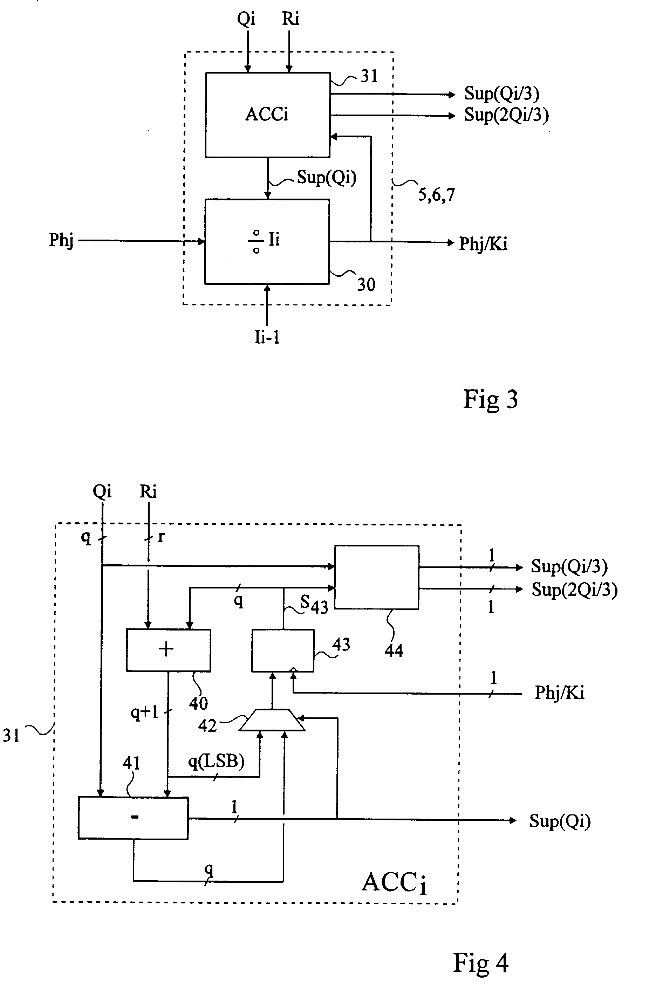

Selon l'invention et dans l'exemple représenté, chaque compensateur de glissement de phase 8, 9 ou 10 est commandé par deux signaux SUP(Qᵢ/3) et SUP(2Qᵢ/3) issus du diviseur fractionnel, respectivement 5, 6 ou 7 auquel il est associé. La forme et le rôle de ces deux signaux SUP(Qᵢ/3) et SUP(2Qᵢ/3) seront mieux compris en relation avec les figures 3 et 6.

Comme le montre la figure 2, la PLL 1 comprend un oscillateur commandé en tension (VCO) 20 qui délivre une fréquence rapide F_{H}. La fréquence rapide F_{H} est synchronisée sur une fréquence de référence F_{ref} au moyen d'un comparateur de phase 22 qui délivre un signal d'erreur de phase e à un filtre 23 dont la sortie c commande l'oscillateur 20. On utilise un oscillateur 20 fournissant un nombre impair n (ici n = 3) de signaux d'horloge, respectivement Ph₁, Ph₂ et Ph₃, à la fréquence F_{H}. Un signal d'horloge Phⱼ, appelé phase d'horloge, est en retard, par rapport au précédent Phⱼ₋₁ et dans l'exemple représenté, de deux tiers de la période T_{H} de la fréquence rapide F_{H}. L'oscillateur 20 est, par exemple, un oscillateur en anneau à n (ici n = 3) inverseurs, respectivement 24, 25 et 26, dont le courant d'alimentation est réglé par le signal de commande c issu du filtre 23. Aux sorties des inverseurs 24, 25 et 26, on prélève les phases d'horloge respectives Ph₁, Ph₂ et Ph₃. La phase Ph₁ est fournie à un diviseur de fréquence 27 dont la sortie est envoyée au comparateur de phase 22. Par le bouclage de la sortie de l'inverseur 24 sur l'entrée de l'inverseur 26, la phase Ph₃ est en retard 2T_{H}/3 par rapport à la phase Ph₂ qui est elle-même en retard de 2T_{H}/3 par rapport à la phase Ph₁. Une phase (par exemple Ph₂) est retardée d'un tiers de la période T_{H} par rapport à la phase (par exemple Ph₃) qui lui est la plus proche dans le sens de circulation de l'oscillateur en anneau.

Une caractéristique de la présente invention est que le synthétiseur de fréquences comporte un même nombre m d'étages associés à chaque phase Phⱼ de la fréquence F_{H} délivrée par la PLL 1. En d'autres termes, le nombre d'étages d'un synthétiseur de fréquences selon l'invention est un multiple entier m du nombre n de phases Phⱼ délivrées par la PLL 1, et la sortie de chaque inverseur 24, 25 ou 26 de l'oscillateur 20 est envoyée à un même nombre m (à la figure 1, m = 1) d'étages.

Un avantage d'une telle architecture est que cela assure un équilibre des charges en sorties des inverseurs 24, 25 et 26 de l'oscillateur 20. On garantit ainsi que le retard apporté par chaque inverseur 24, 25 ou 26 correspond bien au tiers de la période T_{H} de la fréquence rapide F_{H}. Par ce biais, on assure que chaque inverseur 24, 25 ou 26 apporte le même retard et, par voie de conséquence, que le glissement de phase des signaux d'horloge CLKᵢ est bien limité à un tiers de la période de la fréquence F_{H}.

Bien que pour des raisons de clarté, seuls trois étages 2, 3 et 4 aient été représentés à la figure 1, le synthétiseur peut comporter un nombre d'étages supérieur. Compte tenu de ce qui précède, le nombre d'étages est, dans cet exemple, un multiple de trois, dans la mesure où l'oscillateur 20 de la PLL délivre trois phases Ph₁, Ph₂ et Ph₃.

Pour le cas où la période T_{H} de la fréquence rapide F_{H} impose d'utiliser un nombre d'inverseurs plus important en fonction du retard apporté par chaque inverseur, deux variantes peuvent être mises en oeuvre selon l'invention.

Une première variante consiste à augmenter le nombre n de phases Phⱼ délivrées par la PLL 1 en veillant toujours à ce que la sortie de chaque inverseur soit reliée à un même nombre m d'étages du synthétiseur.

Une deuxième variante consiste à considérer qu'un inverseur 24, 25 ou 26 est en fait constitué de plusieurs inverseurs, le nombre d'inverseurs constituant les inverseurs 24, 25 ou 26 étant le même. Les phases Phⱼ de la fréquence rapide F_{H} sont alors prélevées à intervalles réguliers, par exemple, tous les deux ou trois inverseurs.

D'autres types classiques d'oscillateurs 20 peuvent également être utilisés pourvu qu'ils délivrent le nombre n voulu de phases Phⱼ de la fréquence rapide F_{H}, toutes les phases Phⱼ étant retardées d'un même quotient 1/n de la période T_{H} de la fréquence rapide F_{H} par rapport à la phase qui lui est la plus proche. On pourra, par exemple, avoir recours à une boucle à verrouillage de phase 1 dont le VCO est lui-même constitué d'une boucle à verrouillage de phase auxiliaire d'une fréquence rapide issue d'un oscillateur en anneau sur une fréquence délivrée par un oscillateur à quartz. Un tel mode de réalisation peut être employé, par exemple, si la fréquence rapide souhaitée est élevée (de l'ordre de plusieurs centaines de MHz) et que la fréquence de référence est faible (de l'ordre de quelques dizaines de kHz).

La figure 3 représente la structure d'un mode de réalisation d'un diviseur fractionnel 5, 6 ou 7 (figure 1) selon l'invention.

Le rôle d'un tel diviseur selon l'invention est de fournir, d'une part, un signal Phⱼ/Kᵢ dont la fréquence correspond à la fréquence souhaitée pour le signal d'horloge CLKᵢ auquel le diviseur 5, 6 ou 7 est associé et, d'autre part, les signaux de commande SUP(Qᵢ/3) et SUP(2Qᵢ/3) du compensateur de glissement de phase 8, 9 ou 10 auquel le diviseur, respectivement 5, 6 ou 7, est associé.

Pour obtenir une division fractionnelle d'un taux Kᵢ = Pᵢ/Qᵢ, où Pᵢ et Qᵢ représentent des nombres entiers, on réalise une division par Iᵢ + Rᵢ/Qᵢ, où Iᵢ représente la partie entière du quotient Pᵢ/Qᵢ et où Rᵢ représente le reste de ce quotient, soit Pᵢ - IᵢQᵢ.

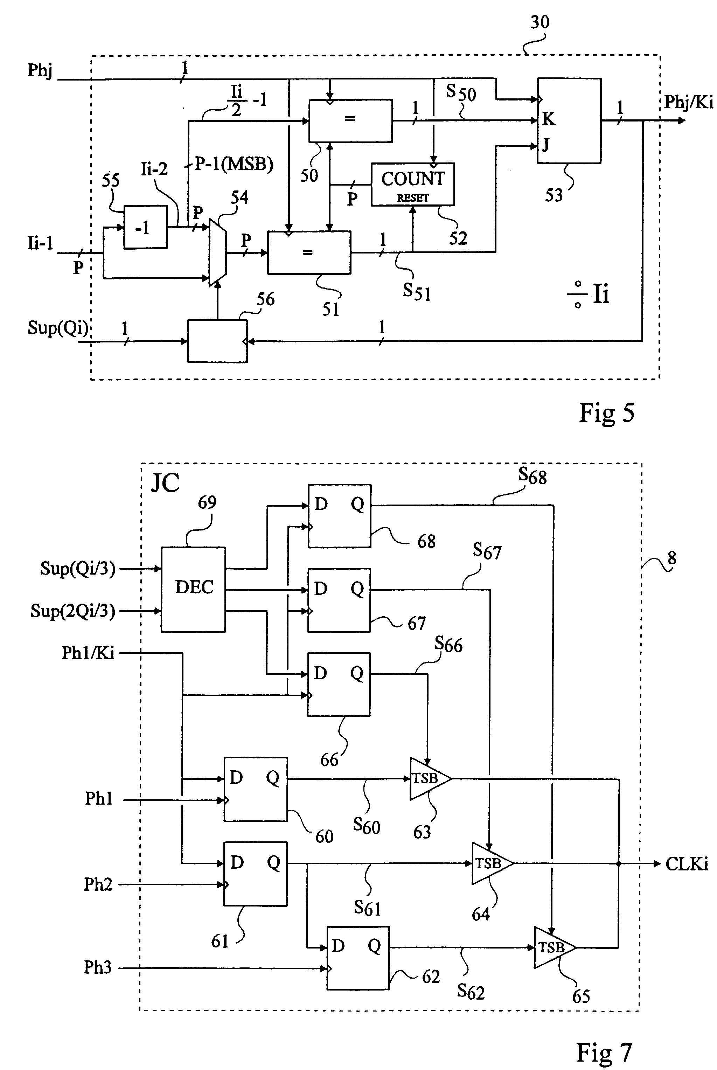

La division fractionnelle est effectuée en comptant les cycles de la phase d'horloge Phⱼ et en transformant chaque cycle en un cycle de fréquence F_{H}/Iᵢ ou F_{H}/(Iᵢ+1). Cette transformation est effectuée au sein d'un diviseur numérique programmable 30 dont un exemple de réalisation sera exposé en relation avec la figure 5. A chaque cycle de fréquence F_{H}/Iᵢ, la valeur de Ri est ajoutée à une valeur contenue dans un accumulateur programmable ACCᵢ 31 et la valeur résultante est comparée au dénominateur Qᵢ du taux Kᵢ. Lorsque la valeur accumulée atteint le dénominateur Qᵢ, on ajoute un cycle de la phase d'horloge Phⱼ au cycle suivant qui est donc de fréquence F_{H}/(Iᵢ+1). Pour le cycle concerné, cela correspond donc à diviser un cycle de la phase d'horloge Phⱼ par Iᵢ+1. Le signal Phⱼ/Kᵢ délivré par le diviseur fractionnel comporte donc, avec une périodicité correspondant au dénominateur Qᵢ, Rᵢ cycles de période (Iᵢ+1)T_{H} et Qᵢ-Rᵢ cycles de période IᵢT_{H}.

Pour ce faire, le diviseur numérique 30 reçoit, outre la phase d'horloge Phⱼ, une valeur Iᵢ-1 qui est prédéfinie en fonction du taux Kᵢ de division souhaité et un signal SUP(Qᵢ) indicateur d'un dépassement de la valeur Qᵢ au sein de l'accumulateur 31. Le diviseur 30 délivre un signal à la fréquence Phⱼ/Kᵢ, modulo Qᵢ, à destination de l'accumulateur 31 et du compensateur de glissement de phase 8, 9 ou 10 auquel le diviseur fractionnel, respectivement 5, 6 ou 7, est associé.

L'accumulateur 31 reçoit, outre le signal Phⱼ/Kᵢ, les valeurs Rᵢ et Qᵢ qui sont des valeurs prédéfinies en fonction du taux Kᵢ de division souhaité. Qᵢ est une valeur sur q bits et Rᵢ est une valeur sur r bits, r étant inférieur ou égal à q dans la mesure où Rᵢ est inférieur à Qᵢ en tant que reste de la division Pᵢ/Qᵢ. L'accumulateur 31 délivre, outre le signal SUP(Qᵢ) à l'attention du diviseur numérique 30, les deux signaux SUP(Qᵢ/3) et SUP(2Qᵢ/3) à l'attention du compensateur de glissement de phase 8, 9 ou 10 auquel le diviseur fractionnel, respectivement 5, 6 ou 7, est associé.

Les signaux SUP(Qᵢ/3) et SUP(2Qᵢ/3) sont des signaux indicateurs du dépassement, respectivement du tiers et des deux tiers, du dénominateur Qᵢ par la valeur contenue dans l'accumulateur 31. Leur rôle sera mieux compris par la suite en relation avec la figure 6.

La figure 4 illustre un mode de réalisation d'un accumulateur 31 tel que représenté à la figure 3.

L'accumulateur ACCᵢ 31 est, selon l'invention, un accumulateur modulo Qᵢ. Pour chaque cycle du signal Phⱼ/Kᵢ, la valeur Ri est ajoutée à la valeur présente dans un sommateur 40.

Un soustracteur 41 calcule, en permanence, la valeur résultante du sommateur 40 diminuée du dénominateur Qᵢ. En pratique, le soustracteur 41 calcule la somme de la valeur délivrée par le sommateur 40 avec le complément à deux du dénominateur Qᵢ. Cela permet d'utiliser la retenue SUP(Qᵢ) de cette opération pour commander un multiplexeur 42 dont deux entrées reçoivent les q bits de poids faible (LSB), respectivement de la valeur résultante délivrée par le sommateur 40 et du résultat délivré par le soustracteur 41. En d'autres termes, le multiplexeur 42 sélectionne la valeur accumulée dans le sommateur 40 tant que cette valeur n'a pas atteint le dénominateur Qᵢ. Lorsque cette valeur est atteinte, le multiplexeur 42 permet, sous commande du signal SUP(Qᵢ), de remettre à zéro l'accumulateur 31.

Une bascule 43 permet de déclencher la sommation à chaque cycle du signal Phⱼ/Kᵢ. On notera que le résultat délivré par le sommateur 40 est sur q+1 bits dans la mesure où ce résultat correspond à l'accumulation avant soustraction de Qᵢ. Ce résultat peut donc atteindre la valeur 2Qᵢ-2.

Un comparateur 44 reçoit, sur une première entrée, le dénominateur Qᵢ et, sur une seconde entrée, la valeur S₄₃ délivrée par la bascule 43, soit le résultat de l'accumulation modulo Qᵢ. Le comparateur 44 examine la valeur accumulée par rapport à un tiers et à deux tiers du dénominateur Qᵢ. Le comparateur 44 délivre les signaux SUP(Qᵢ/3) et SVP(2Qᵢ/3).

La figure 5 illustre un mode de réalisation d'un diviseur numérique 30 tel que représenté à la figure 3.

Le diviseur 30 reçoit la phase Phⱼ dont il doit diviser la fréquence. La phase Phⱼ est envoyée sur les entrées d'horloge de deux comparateurs 50 et 51, d'un compteur 52 et d'une bascule JK 53 chargée de délivrer le signal à la fréquence Phⱼ/Kᵢ modulo Qᵢ.

Le diviseur 30 reçoit également la valeur prédéterminée Iᵢ-1, par exemple programmée sur p bits, et le signal SUP(Qᵢ) issu de l'accumulateur 31.

Un multiplexeur 54 reçoit, sur une première entrée, cette valeur Iᵢ-1 et, sur une seconde entrée, la sortie d'un soustracteur 55 recevant, en entrée, la valeur Iᵢ-1. Le soustracteur 55 retire "1" à la valeur Iᵢ-1 et délivre la valeur Iᵢ-2. Le signal SUP(Qᵢ) est envoyé sur une bascule 56 commandée par le signal Phⱼ/Kᵢ. Le multiplexeur 54 sélectionne, à chaque front montant du signal Phⱼ/Kᵢ, la valeur Iᵢ-2 pour Qᵢ-Rᵢ cycles du signal Phⱼ/Kᵢ et la valeur Iᵢ-1 pour Rᵢ cycles du signal Phⱼ/Kᵢ.

Le compteur 52 est remis à zéro par la sortie S₅₁ du comparateur 51 qui reçoit, en entrées, la valeur délivrée par le multiplexeur 54 et le résultat du compteur 52. En d'autres termes, le compteur 52 est remis à zéro, tous les Iᵢ-2 cycles, en comptant un cycle supplémentaire lorsque la valeur Qᵢ est atteinte. Le recours aux valeurs Iᵢ-1 et Iᵢ-2 est lié au fait que la remise à zéro du compteur 52 est synchronisée par la phase Phⱼ. Ainsi, pour compter Iᵢ cycles de la phase Phⱼ, le résultat du compteur 52 doit être comparé à la valeur Iᵢ-2. Pour compter Iᵢ+1 cycles de la phase Phⱼ, le résultat du compteur 52 doit être comparé à la valeur Iᵢ-1.

La sortie du comparateur 51 est également envoyée sur l'entrée J de la bascule 53. Ainsi, lorsque que la sortie du comparateur 51 est à l'état "1", la sortie Phᵢ/Kᵢ de la bascule 53 est positionnée à "1" au front montant suivant de la phase Phⱼ. La remise à zéro de la sortie Phⱼ/Kᵢ de la bascule 53 est déclenchée par son entrée K qui reçoit la sortie S₅₀ du comparateur 50. Le comparateur 50 reçoit le résultat du compteur 52 et les p-1 bits de poids fort (MSB) de sortie du soustracteur 55. En d'autres termes, le comparateur 50 compare le résultat du compteur 52 avec la valeur (Iᵢ/2)-1 en ne tenant compte que de la partie entière de cette valeur dans la mesure où le bit de poids faible n'est pas utilisé.

La figure 6 illustre le fonctionnement du diviseur fractionnel selon l'invention tel que représenté aux figures 3 à 5. On suppose, pour l'établissement de cette figure que le taux Kᵢ de division est 21/4. Ainsi, Qᵢ est égal à 4, Iᵢ est égal à 5 et Rᵢ est égal à 1. La figure 6 représente, sous forme de chronogrammes, la forme des signaux Phⱼ, S₅₀, S₅₁, Phⱼ/Kᵢ, SUP(Qᵢ), SUP(Qᵢ/3), SUP(2Qᵢ/3) et le résultat délivré par le compteur 52.

Comme le montre cette figure, le passage à l'état "1" du signal S₅₁, qui entraîne au front montant suivant de la phase Phⱼ le passage à l'état "1" de la sortie Phⱼ/Kᵢ, est provoqué par le front montant de la phase Phⱼ où le compteur 52 est à "3" (Iᵢ-2) et, toutes les quatre périodes (Qᵢ = 4) du signal Phⱼ/Kᵢ, où le compteur 52 est à "4" (Iᵢ-1). Le signal S₅₁ reste à l'état "1" pendant une période T_{H} de la phase Phⱼ.

Le passage à l'état "1" du signal S₅₀, qui entraîne au front montant suivant de la phase Phⱼ le passage à l'état "0" de la sortie Phⱼ/Kᵢ, est provoqué par le front montant de la phase Phⱼ où le compteur 52 est à "1" (partie entière de Iᵢ/2 - 1). Le signal S₅₀ reste à l'état "1" pendant une période T_{H} de la phase Phⱼ.

La remise à zéro de la sortie du compteur 52 est provoquée par le passage à l'état "1" du signal S₅₁, soit par le front montant de la phase Phⱼ qui suit le front déclencheur du passage à l'état "1" de la sortie S₅₁.

Du point de vue de l'accumulateur 31, le passage à l'état "1" du signal SUP(Qᵢ/3) est provoqué au deuxième front montant du signal Phⱼ/Kᵢ qui suit une remise à zéro du compteur sur la base de la valeur "4" (Iᵢ-1). Le passage à l'état "1" du signal SUP(2Qᵢ/3) est provoqué par le front montant suivant (instant t₃) du signal Phⱼ/Kᵢ, le signal SUP(Qᵢ/3) restant à l'état "1". Le passage à l'état "1" du signal SUP(Qᵢ) est provoqué par le même front montant (instant t₃) du signal Phⱼ/Kᵢ, les signaux SUP(Qᵢ/3) et SUP(2Qᵢ/3) restant à l'état "1".

En effet, on suppose qu'à un instant t'₀, le signal SUP(Qᵢ) repasse à l'état "0" suite à un front montant (instant t₀) du signal Phⱼ/Kᵢ. Les signaux SUP(Qᵢ/3) et SUP(2Qᵢ/3) repassent également à l'état "0".

Comme le front montant précédent du signal Phⱼ/Kᵢ a provoqué le passage à l'état "1" du signal SUP(Qᵢ), au front montant suivant du signal Phⱼ/Kᵢ (instant t₁), le résultat présent en sortie du sommateur 40 est 0001 (0 + Rᵢ, c'est-à-dire 000 + 01).

Ainsi, à l'instant t₁, la bascule 43 délivre la valeur 001 qui correspond aux q (ici q = 3) bits de poids faible présents en sortie du sommateur 40. La sortie du sommateur 40 devient donc 0010 (001 + 01). Le résultat de la somme du complément à deux [0]100 de la valeur de Qᵢ (100) avec le résultat 0010 délivré par le sommateur 40 devient [0]110. La retenu étant à [0], le signal SUP(Qᵢ) reste à l'état "0". Le multiplexeur 42 sélectionne donc la valeur 010 correspondant aux trois bits de poids faible du sommateur 40. De plus, les signaux SUP(Qᵢ/3) et SUP(2Qi/3) restent à l'état "0" dans la mesure où ils sont obtenus sur la base de la valeur délivrée par la bascule 43, soit 001.

Au front montant suivant du signal Phⱼ/Kᵢ (instant t₂), la bascule 43 délivre la valeur 010. La sortie du sommateur 40 devient 0011. La somme du complément à deux de la valeur de Qᵢ avec le résultat délivré par le sommateur 40 devient donc [0]111. Le signal SUP(Qᵢ) reste à l'état "0". Le multiplexeur 42 sélectionne les trois bits de poids faible 011 du sommateur 40. De plus, le signal SUP(Qᵢ/3) passe à l'état "1" à un instant t'₂ qui est en retard par rapport à l'instant t₂ du temps nécessaire à la traversée du comparateur 44. Le signal SUP(2Qi/3) reste à l'état "0".

A l'instant t₃, la bascule 43 délivre la valeur 011. La sortie du sommateur 40 devient 0100. La somme du complément à deux de la valeur de Qᵢ avec le résultat délivré par le sommateur 40 devient donc [1]000. Le signal SUP(Qᵢ) passe donc à l'état "1" à un instant t'₃ qui est en retard, par rapport à l'instant t_{3,} du temps nécessaire à la traversée du sommateur 40 et du soustracteur 41. Le multiplexeur 42 sélectionne alors le résultat délivré par le soustracteur 41, soit 000. De plus, le signal SUP(2Qᵢ/3) passe à l'état "1"

A un instant t₄, la bascule 43 délivre la valeur 000. La sortie du sommateur 40 devient 0001. La somme du complément à deux de la valeur de Qᵢ avec le résultat délivré par le sommateur 40 devient donc [0]101. le signal SUP(Qᵢ) repasse donc à l'état "0" (instant t'₄) ainsi que les signaux SUP(Qᵢ/3) et SUP(2Qᵢ/3).

Comme on peut le constater sur la figure 6, les instants t₄ et t₀ sont distants l'un de l'autre de 21 périodes T_{H} de la fréquence rapide F_{H} et 4 cycles du signal Phⱼ/Kᵢ sont présents entre les instants t₀ et t₄.

On notera que l'évolution des signaux SUP(Qi/3) et SUP(2Qi/3) n'est pas directement liée à l'évolution du signal SUP(Qi), et réciproquement. En effet, les signaux SUP(Qi/3) et SUP(2Qi/3) sont liés à la valeur délivrée par la sortie de la bascule 43 alors que le signal SUP(Qi) est lié à la retenue délivrée par le soustracteur 41.

La limite de fonctionnement d'un accumulateur 31 selon l'invention est fixée par le temps nécessaire à la traversée du sommateur 40, du soustracteur 41 et du multiplexeur 42. En effet, une nouvelle valeur doit être présente en sortie du multiplexeur 42 avant qu'un nouveau front montant du signal Phⱼ/Kᵢ ne commande la bascule 43. On utilisera, par exemple, pour réaliser le sommateur 40 et le soustracteur 41, des additionneurs dits à verrouillage qui permettent d'effectuer des calculs sur des groupes de bits en parallèle.

La limite de fonctionnement d'un diviseur numérique 30 selon l'invention est fixée par le temps nécessaire au changement d'état de la sortie du compteur 52 suite à un front montant de la phase Phⱼ et à la traversée des comparateurs 50 ou 51. En effet, si un front montant de la phase Phⱼ arrive alors que les sorties S₅₀ et S₅₁ n'ont pas encore pris en compte le résultat du compteur 52 dû au front montant précédent de la phase Phⱼ, un cycle de comptage est perdu. De plus, un diviseur numérique 30 selon l'invention ne fonctionne que si Iᵢ est supérieur ou égal à 3. En effet, dans le cas contraire, les signaux S₅₀ et S₅₁ de sorties des comparateurs 50 et 51 sont synchrones lorsque le compteur 52 compte jusqu'à Iᵢ-2.

Comme le montre la figure 6, le signal Phⱼ/Kᵢ présente un glissement de phase (jitter) correspondant à une période T_{H} de la fréquence rapide F_{H}. Ce glissement de phase se produit Rᵢ fois toutes les Qi périodes du signal Phⱼ/Kᵢ.

La figure 7 illustre un mode de réalisation d'un compensateur de glissement de phase selon l'invention dont le rôle est de réduire le glissement de phase à 1/n (ici 1/3) fois la période T_{H} de la fréquence rapide F_{H}.

Pour ce faire, chaque compensateur 8, 9 ou 10 (figure 1) synchronise, individuellement, chaque cycle du signal Phⱼ/Kᵢ délivré par le diviseur fractionnel, respectivement 5, 6 ou 7, auquel il est associé sur une des phases Phⱼ délivrées par l'oscillateur 20 (figure 2). On assure ainsi que le glissement de phase (jitter) du signal d'horloge CLKᵢ délivré par chaque compensateur 8, 9 ou 10 par rapport à la fréquence de référence F_{ref} est limité, dans cet exemple, à un tiers de la période T_{H} de la fréquence rapide F_{H} de l'oscillateur 20.

A la figure 7, on suppose que la division fractionnelle est effectuée sur la base de la phase Ph₁. Le compensateur 8 représenté à la figure 7 correspond donc, par exemple, à celui de l'étage 2 de la figure 1.

Les trois phases Ph₁, Ph₂, Ph₃ servent à commander des bascules D de déphasage, respectivement 60, 61 et 62 que comporte chaque compensateur 8, 9 ou 10. Les bascules 60 et 61 commandées par les phases Ph₁ et Ph₂ reçoivent, en entrée D, le signal Ph₁/Kᵢ délivré par le diviseur fractionnel 5. La bascule 62 commandée par la phase Ph₃ reçoit, en entrée, la sortie non- inverseuse Q de la bascule 61.

Les sorties non-inverseuses Q des bascules 60, 61 et 62 sont envoyées sur des registres tampon à trois états (TSB), respectivement 63, 64 et 65. Les sorties des registres 63, 64 et 65 sont reliées et constituent la sortie du compensateur qui délivre le signal d'horloge CLKᵢ.

Chaque registre tampon 63, 64 ou 65 est commandé par la sortie non-inverseuse Q d'une bascule D de commande, respectivement 66, 67 ou 68, échantillonnée (commandée) par le signal Ph₁/Kᵢ et qui reçoit, en entrée D, une sortie d'un décodeur logique DEC 69. Le rôle du décodeur 69 est de sélectionner, en fonction de l'état des signaux SUP(Qᵢ/3) et SUP(2Qᵢ/3), sur quelle phase Phⱼ de la fréquence rapide F_{H} doit être synchronisé le front montant suivant du signal d'horloge CLKᵢ. En d'autres termes, les registres tampon 63, 64 et 65 constituent un commutateur, à trois entrées S₆₀, S₆₁ et S₆₂ et une sortie CLKᵢ, commandé par les signaux de sorties S₆₆, S₆₇ et S₆₈ des bascules D, respectivement 66, 67 et 68.

La sortie S₆₆ est à l'état "1" quand le résultat S₄₃ (figure 4) de l'accumulateur modulo Qᵢ 31 est supérieur ou égal à Qᵢ/3 et inférieur à 2Qᵢ/3. La sortie S₆₆ est, par exemple, obtenue par une combinaison logique de type "OU Exclusif" des signaux SUP(Qᵢ/3) et SUP(2Qᵢ/3).

La sortie S₆₇ est à l'état "1" quand le résultat S₄₃ est supérieur ou égal à 0 et inférieur à Qᵢ/3. La sortie S₆₇ est, par exemple, obtenue par l'inverse du signal SUP(Qi/3).

La sortie S₆₈ est à l'état "1" quand le résultat S₄₃ est supérieur ou égal à 2Qᵢ/3 et inférieur à Qᵢ. La sortie S₆₈ correspond, par exemple, au signal SUP(2Qᵢ/3).

La réalisation pratique du décodeur 69 est à la portée de l'homme du métier en fonction des indications fonctionnelles données ci-dessus.

Si le compensateur, par exemple 9 (figure 1), est associé à un diviseur fractionnel (par exemple 6) utilisant la phase Ph₂, les bascules 60, 61 et 62 sont respectivement commandées par les phases Ph₂, Ph₃ et Ph₁.

Si le compensateur, par exemple 10 (figure 1), est associé à un diviseur fractionnel (par exemple 7) utilisant la phase Ph₃, les bascules 60, 61 et 62 sont respectivement commandées par les phases Ph₃, Ph₁ et Ph₂.

Les bascules 60 et 61 reçoivent toujours, en entrée D, le signal Phⱼ/Kᵢ du diviseur fractionnel auquel le compensateur est associé. La bascule 62 reçoit toujours, en entrée D, la sortie de la bascule 61.

En généralisant l'exposé de la figure 7, le nombre de bascules de déphasage, de registres tampon et de bascules de commande correspond au nombre n de phases Phⱼ délivrées par l'oscillateur 20 (figure 1) de la PLL 1.

De même, le nombre de signaux SUP(Qᵢ/n), SVP(2Qᵢ/n), ..., SUP((n-1)Qᵢ/n), délivrés par chaque accumulateur 31 et indicateurs de la position de chaque front montant du signal Phⱼ/Kᵢ de chaque diviseur numérique 30 par rapport au quotient par n du dénominateur Qᵢ du taux fractionnel Kᵢ, correspond à n-1. Du point de vue des bascules de déphasage qui reçoivent les phases d'horloge Phⱼ, chaque bascule échantillonne le signal à la fréquence Phⱼ/Kᵢ qu'elle reçoit sur son entrée D par la phase Phⱼ qu'elle reçoit sur son entrée d'horloge pour obtenir, en sortie des bascules de déphasage, des signaux à la fréquence Phⱼ/Kᵢ retardés de xT_{H}/n, x prenant les valeurs 0, 1, ..., n-1.

Un avantage du synthétiseur selon la présente invention est qu'il permet de générer plusieurs horloges CLKᵢ qui sont toutes synchrones avec la fréquence de référence F_{ref} et dont le glissement de phase est limité, dans l'exemple décrit, à un tiers de la période T_{H} la fréquence rapide F_{H} de l'oscillateur 20 de la boucle à verrouillage de phase 1.

Un autre avantage de la présente invention est que tous les constituants des différents étages du synthétiseur sont identiques pour une même PLL 1. En effet, tous les accumulateurs 31, diviseurs numériques 30 et compensateurs de glissement de phase du synthétiseur selon l'invention peuvent être réalisés exactement de la même manière pour tous les étages. Le fonctionnement des diviseurs fractionnels est programmable par les valeurs Iᵢ-1, Qᵢ et Rᵢ qui y sont introduites. De plus, seules les connexions des entrées D des bascules de déphasage des compensateurs dépendent des phases Phⱼ utilisées par les diviseurs fractionnels auxquels les compensateurs sont respectivement associés. Cela rend le synthétiseur selon l'invention aisément intégrable.

La figure 8 illustre le fonctionnement d'un synthétiseur de fréquences selon l'invention. Pour des raisons de clarté, seuls les signaux utiles à la génération du signal CLK₁ généré par le premier étage 2 ont été représentés. La figure 8 représente, sous forme de chronogrammes, la forme des signaux Ph₁, Ph₂, Ph₃, Ph₁/K₁, SUP(Q₁/3), SUP(2Q₁/3), S₆₀, S₆₁, S₆₂, S₆₆, S₆₇, S₆₈ et CLK₁. Dans l'exemple représenté, on suppose que le taux de division K₁ est égal à 15/4. En d'autres termes, on suppose que I₁ est égal à 3, que Q₁ est égal à 4 et que R₁ est égal à 3.

L'obtention des signaux Ph₁/K₁, SUP(Q₁/3) et SUP(2Q₁/3) se déduit de l'exposé du fonctionnement du diviseur fractionnel effectué en relation avec les figures 3 à 6. Bien qu'il n'ait pas été représenté, le signal SUP(Q₁) est à l'état "1" trois (R₁ = 3) cycles sur quatre (Q₁ = 4) du signal Ph₁/K₁.

Le signal S₆₀ correspond au signal Ph₁/K₁ retardé d'une période T_{H} de la fréquence rapide F_{H}.

Le signal S₆₁ correspond au signal Ph₁/K₁ retardé de 2/3 d'une période T_{H} de la fréquence rapide F_{H}.

Le signal S₆₂ correspond au signal S₆₁ retardé de 2/3 d'une période T_{H} de la fréquence rapide F_{H}, soit au signal Ph₁/K₁ retardé de 4/3 d'une période T_{H} de la fréquence rapide F_{H}.

Le signal S₆₆ est à l'état "1" lorsque le signal SUP(Q₁/3) est à l'état "1" et que le signal SUP(2Q₁/3) est à l'état "0", mais avec un retard d'un cycle du signal Ph₁/K₁. En effet, bien que le décodeur 69 positionne l'entrée D de la bascule 66 dès que les signaux SUP(Q₁/3) et SUP(2Q₁/3) sont, respectivement à l'état "1" et à l'état "0", la bascule 66 est commandée par le signal Ph₁/K₁.

Le signal S₆₇ est à l'état "1" lorsque les signaux SUP(Q₁/3) et SUP(2Q₁/3) sont à l'état "0", toujours en étant retardé d'un cycle du signal Ph₁/K₁.

Le signal S₆₈ est à l'état "1" lorsque les signaux SUP(Q₁/3) et SUP(2Q₁/3) sont à l'état "1", toujours en étant retardé d'un cycle du signal Ph₁/K₁.

Les registres tampon 63, 64 et 65 sont commandés par les signaux, respectivement S₆₆, S₆₇ et S₆₈. Le signal CLK₁ est généré à partir des trois signaux S60, S61 et S62 qui sont sélectionnés en fonction des signaux S₆₆, S₆₇ et S₆₈.

Comme on peut le constater, le glissement de phase (jitter) du signal CLK₁ correspond à un tiers d'une période T_{H} de la fréquence rapide F_{H}.

Le fonctionnement illustré ci-dessus est le même pour les deux autres étages 3 et 4 en utilisant la phase Phⱼ adaptée.

On notera que les signaux de sorties des bascules de déphasage sont, en fait, tous retardés, par rapport au signal Phⱼ/Kᵢ, d'un temps T₀ en plus du retard xT_{H}/n. Ce retard fixe supplémentaire T₀ est lié aux temps de prépositionnement et de maintien des bascules. En effet, pour une fréquence F_{H} élevée, le signal Phⱼ/Kᵢ ne peut pas être retardé d'une valeur T_{H}/n par le simple échantillonnage avec une phase d'horloge retardée de T_{H}/n. Comme les retards générés sont forcément des multiples de T_{H}/n, le retard fixe supplémentaire T₀ est également un multiple de T_{H}/n. Ainsi, les n signaux de sorties des différentes bascules de déphasage correspondent au signal Phⱼ/Kᵢ retardé de T₀, T₀+T_{H}/n, ..., T₀+xT_{H}/n, ..., T₀+(n-1)T_{H}/n, où T₀ est un multiple entier α du retard minimum βT_{H}/n que l'on peut obtenir au moyen des bascules en raison de leurs temps de prépositionnement et de maintien (T₀ = αβT_{H}/n). En d'autres termes, le signal de sortie d'une bascule de rang x correspond au signal Phⱼ/Kᵢ retardé de T₀+xT_{H}/n avec x prenant les valeurs 0, 1, 2, ..., n-1. Le coefficient multiplicateur α doit satisfaire la condition α ∫ (β-1)/(n-β).

Dans l'exemple représenté à la figure 8, on a n = 3, β = 2. En effet, le signal S₆₀ est obtenu en utilisant le front montant du signal Ph₁. Parmi les signaux de sorties des bascules de déphasage, celui qui est le plus proche du signal T_{H}/n est le signal S₆₁ qui est retardé de 2T_{H}/3 par rapport à Ph₁/Kᵢ. Le coefficient multiplicateur α est égal à 1. La condition α ∫ (β-1)/(n-β) est bien respectée. Les signaux de sorties des bascules 60, 61 et 62 correspondent bien à Ph₁/Kᵢ retardé de T₀, soit Ph₁/Kᵢ retardé de 2T_{H}/3 (S₆₁), Ph₁/Kᵢ retardé de T₀ + T_{H}/3, soit Ph₁/Kᵢ retardé de T_{H} (S₆₀) et Ph₁/Kᵢ retardé de T₀ + 2T_{H}/3, soit Ph₁/Kᵢ retardé de 4T_{H}/3 (S₆₂).

Si, par exemple, l'oscillateur 20 délivre 9 phases d'horloge (n = 9) et que le retard minimum que l'on peut obtenir entre deux échantillonnages au moyen des bascules est de 7T_{H}/9 (β = 7), le coefficient multiplicateur α sera de 3. En effet, 3 est le plus petit nombre entier qui est supérieur ou égal à (β-1)/(n-β). Les 9 signaux de sorties des bascules recevant les neuf phases Phⱼ seront retardés de 21T_{H}/9, 22T_{H}/9, 23T_{H}/9, 24T_{H}/9, 25T_{H}/9, 26T_{H}/9, 27T_{H}/9, 28T_{H}/9, 29T_{H}/9.

On notera que si T₀ est supérieur ou égal à T_{H}, les signaux de sorties des bascules de commande des registres tampons à trois états doivent être retardés de T₀.

La fréquence rapide F_{H} de l'oscillateur est, par exemple, comprise entre environ 150 et 300 MHz et la fréquence de référence F_{ref} est, par exemple, comprise entre environ 500 kHz et 40 MHz. Les diviseurs fractionnels sont, par exemple, réalisés pour fonctionner dans une plage de valeur Iᵢ allant de 3 à 16. Dans ce cas, les compteurs 52 des diviseurs numériques 30 sont des compteurs sur 4 bits dans la mesure où ils comptent jusqu'à Iᵢ-1.

A titre d'exemple particulier de réalisation, appliqué à la génération de signaux d'horloge pour un décodeur MPEG, la fréquence F_{H} de l'oscillateur 20 est d'environ 250 MHz et la fréquence de référence F_{ref} est de l'ordre de 10 MHz.

Bien entendu, la présente invention est susceptible de diverses variantes et modifications qui apparaîtront à l'homme de l'art. En particulier, chacun des composants décrits pourra être remplacé par un ou plusieurs éléments remplissant la même fonction.

De plus, le nombre n de phases Phⱼ délivrées par l'oscillateur 20 peut être modifié en fonction du glissement maximal auquel on souhaite limiter le glissement de phase des signaux d'horloge CLKᵢ délivrés. Les compensateurs de glissement de phase et les accumulateurs 31 des diviseurs fractionnels seront alors adaptés en conséquence.

En outre, bien que l'on ait fait référence dans la description qui précède à un synthétiseur comportant un nombre d'étages identique au nombre n de phases Phⱼ délivrées par l'oscillateur 20, le nombre d'étages pourra être modifié pourvu qu'il reste un multiple du nombre n de phases Phⱼ et qu'un même nombre m de diviseurs fractionnels utilise chaque phase Phⱼ de la fréquence rapide F_{H}.

## Revendications

1. Synthétiseur de fréquences comprenant une boucle à verrouillage de phase (1) dont un oscillateur (20) fournit un nombre impair n de phases (Ph₁, ..., Phⱼ, ..., Phₙ) de retards croissants d'un signal d'horloge rapide (F_{H}) synchronisé sur une fréquence de référence (F_{ref}), caractérisé en ce que chacune desdites n phases (Phⱼ) est envoyée sur un même nombre m de diviseurs fractionnels programmables (5, 6, 7) dont les sorties respectives (Phⱼ/Kᵢ, SUP(Qᵢ/n), SUP(2Qᵢ/n), ..., SUP((n-1)Qᵢ/n)) sont envoyées sur m compensateurs de glissement de phase (8, 9, 10) qui délivrent chacun, à partir desdites n phases (Ph₁, ..., Phⱼ, ..., Phₙ), un signal d'horloge (CLK₁, ..., CLKᵢ, ..., CLKₘ) synchronisé sur ladite fréquence de référence (F_{ref}).

2. Synthétiseur de fréquences selon la revendication 1, caractérisé en ce que chaque diviseur fractionnel (5, 6, 7) comporte un diviseur numérique programmable (30) qui délivre un signal de sortie (Phⱼ/Kᵢ) à une fréquence correspondant, modulo le dénominateur (Qᵢ) du taux (Kᵢ) de division fractionnelle, à la fréquence rapide (F_{H}) divisée par ledit taux fractionnel (Kᵢ), et un accumulateur programmable (31) qui délivre n-1 signaux (SUP(Qᵢ/n), SUP(2Qᵢ/n), ..., SUP((n-1)Qᵢ/n)) indicateurs de la position de chaque front montant dudit signal de sortie (Phⱼ/Kᵢ) du diviseur numérique (30) par rapport au quotient, par le nombre n de phases (Phⱼ), du dénominateur (Qᵢ) dudit taux fractionnel (Kᵢ).

3. Synthétiseur de fréquences selon la revendication 2, caractérisé en ce que ledit accumulateur (31) configure ledit diviseur numérique (30) entre un mode de fonctionnement où il divise ladite fréquence rapide (F_{H}) par la partie entière (Iᵢ) dudit taux (Kᵢ) de division fractionnelle et un mode de fonctionnement où il divise ladite fréquence rapide (F_{H}) par ladite partie entière (Iᵢ) majorée de l'unité, ledit accumulateur (31) étant synchronisé par ledit signal (Phⱼ/Kᵢ) de sortie dudit diviseur numérique (30).

4. Synthétiseur de fréquences selon la revendication 3, caractérisé en ce que la partie entière (Iᵢ) du taux (Kᵢ) de division fractionnelle est au moins égale à 3.

5. Synthétiseur de fréquences selon la revendication 3 ou 4, caractérisé en ce que ledit diviseur numérique (30) est programmé par ladite partie entière (Iᵢ), diminuée de l'unité, et reçoit ladite phase (Phⱼ) utilisée par ledit diviseur fractionnel (5, 6, 7) auquel il est intégré, ledit accumulateur (31) étant programmé par le dénominateur (Qᵢ) dudit taux (Kᵢ) de division fractionnelle ainsi que par le reste (Rᵢ) de la division du numérateur (Pᵢ) dudit taux fractionnel (Kᵢ) par ledit dénominateur (Qᵢ).

6. Synthétiseur de fréquences selon l'une quelconque des revendications 2 à 5, caractérisé en ce que chaque compensateur de glissement de phase (8, 9, 10) comporte un commutateur, à n entrées (S₆₀, S₆₁, S₆₂) et une sortie (CLKᵢ), commandé par n signaux (S₆₆, S₆₇, S₆₈) délivrés par n bascules D (66, 67, 68) échantillonnées par ledit signal de sortie (Phⱼ/Kᵢ) dudit diviseur numérique (30) auquel le compensateur (8, 9, 10) est associé, chaque bascule de commande (66, 67, 68) recevant une sortie d'un décodeur logique (69) qui reçoit, en entrée, lesdits n-1 signaux (SUP(Qᵢ/n), SUP(2Qᵢ/n), ..., SUP((n-1)Qᵢ/n)) délivrés par ledit accumulateur (31).

7. Synthétiseur de fréquences selon la revendication 6, caractérisé en ce que chaque entrée dudit commutateur est relié à une sortie d'une bascule D de déphasage (60, 61, 62), une première bascule de déphasage (60) étant commandée par la phase (Phⱼ) de la fréquence rapide (F_{H}) qui est utilisée par le diviseur fractionnel (5, 6, 7) associé au compensateur (8, 9, 10) concerné, les autres bascules de déphasage (61, 62) étant commandées, chacune, par une autre desdites phases de la fréquence rapide (F_{H}).

8. Synthétiseur de fréquences selon la revendication 6 ou 7, caractérisé en ce que tous les compensateurs de glissement de phase (8, 9, 10) et tous les diviseurs fractionnels (5, 6, 7) qu'il comporte sont de constitution identique, deux étages (2, 3, 4) du synthétiseur se distinguant par la phase (Phⱼ) que reçoit la première bascule de déphasage (60) de leur compensateur de glissement de phase (8, 9, 10) et/ou par les valeurs (Qᵢ, Rᵢ, Iᵢ-1) introduites pour programmer leur diviseur fractionnel (5, 6, 7).

9. Synthétiseur de fréquences selon l'une quelconque des revendications 1 à 8, caractérisé en ce que ledit oscillateur (20) de la boucle à verrouillage de phase (1) délivre trois phases (Ph₁, Ph₂, Ph₃) de la fréquence rapide (F_{H}).

## Claims

1. A frequency synthesizer including a phase-locked loop (1) having one oscillator (20) which supplies an odd number n of phases (Ph₁ ..., Phⱼ ..., Phₙ) with increasing delays of a fast clock signal (F_{H}) synchronized on a reference frequency (F_{ref}), characterized in that each of said n phases (Phⱼ) is sent onto a same number m of programmable fractional dividers (5, 6, 7) having their respective outputs (Phⱼ/Kᵢ, SUP(Qᵢ/n), SUP(2Qᵢ/n) ..., SUP((n-1)Qᵢ/n)) sent onto m jitter compensators (8, 9, 10), each of which issues, based on said n phases (Ph₁, ..., Phⱼ ..., Phₙ), a clock signal (CLK₁ ..., CLKᵢ, ..., CLKₘ) synchronized on said reference frequency (F_{ref}).

2. A frequency synthesizer according to claim 1, characterized in that each fractional divider (5, 6, 7) includes a programmable digital divider (30) which issues an output signal (Phⱼ/Kᵢ) at a frequency corresponding, modulo the denominator (Qᵢ) of the fractional division ratio (Kᵢ), to the fast frequency (F_{H}) divided by said fractional ratio (Kᵢ), and a programmable accumulator (31) which issues n-1 signals (SUP(Qᵢ/n), SUP(2Qᵢ/n), ..., SUP((n-1)Qᵢ/n)) indicating the position of each rising edge of said output signal (Phⱼ/Kᵢ) of the digital divider (30) with respect to the quotient, by the number n of phases (Phⱼ), of the denominator (Qᵢ) of said fractional ratio (Kᵢ).

3. A frequency synthesizer according to claim 2, characterized in that said accumulator (31) configures said digital divider (30) between an operating mode where it divides said fast frequency (F_{H}) by the integer part (Iᵢ) of said fractional division ratio (Kᵢ) and an operating mode where it divides said fast frequency (F_{H}) by said integer part (Iᵢ) plus one, said accumulator (31) being synchronized by said output signal (Phⱼ/Kᵢ) of said digital divider (30).

4. A frequency synthesizer according to claim 3, characterized in that the integer part (Iᵢ) of the fractional division ratio (Kᵢ) is at least equal to 3.

5. A frequency synthesizer according to claim 3 or 4, characterized in that said digital divider (30) is programmed by said integer part (Iᵢ), minus one, and receives said phase (Phⱼ) used by said fractional divider (5, 6, 7) to which it is integrated, said accumulator (31) being programmed by the denominator (Qᵢ) of said fractional division ratio (Kᵢ) as well as by the remainder (Rᵢ) of the division of the numerator (Pᵢ) of said fractional ratio (Kᵢ) by said denominator (Qᵢ).

6. A frequency synthesizer according to any of claims 2 to 5, characterized in that each jitter compensator (8, 9, 10) includes a switch, with n inputs (S₆₀, S₆₁, S₆₂) and one output (CLKᵢ), controlled by n signals (S₆₆, S₆₇, S₆₈) issued by n D flip-flops (66, 67, 68) sampled by said output signal (Phⱼ/Kᵢ) of said digital divider (30) to which the compensator (8, 9, 10) is associated, each control flip-flop (66, 67, 68) receiving an output of a logic decoder (69) which receives, as an input, said n-1 signals (SUP(Qᵢ/n), SUP(2Qᵢ/n) ..., SUP((n-1)Qᵢ/n)) issued by said accumulator (31).

7. A frequency synthesizer according to claim 6, characterized in that each input of said switch is connected to an output of a dephasing D flip-flop (60, 61, 62), a first dephasing flip-flop (60) being controlled by the phase (Phⱼ) of the fast frequency (F_{H}) which is used by the fractional divider (5, 6, 7) associated with the compensator (8, 9, 10) involved, the other dephasing flip-flops (61, 62) being each controlled by another one of said phases of the fast frequency (F_{H}).

8. A frequency synthesizer according to claim 6 or 7, characterized in that all the jitter compensators (8, 9, 10) and all the fractional dividers (5, 6, 7) it includes have an identical constitution, two stages (2, 3, 4) of the synthesizer being distinguished by the phase (Phⱼ) received by the first dephasing flip-flop (60) of their jitter compensator (8, 9, 10) and/or by the values (Qᵢ, Rᵢ, Iᵢ -1) introduced to program their fractional divider (5, 6, 7).

9. A frequency synthesizer according to any of claims 1 to 8, characterized in that said oscillator (20) of the phase-locked loop (1) issues three phases (Ph₁, Ph₂, Ph₃) of the fast frequency (F_{H}).

## Patentansprüche

1. Frequenzsynthetisierer mit einer Phasenverriegelungsschleife (1), wobei ein Oszillator (20) eine ungerade Anzahl n von Phasen (Ph₁, ..., Phⱼ, ..., Phₙ) mit wachsender Nacheilung zu einem schnellen, auf eine Referenzfrequenz (F_{ref}) synchronisierten Taktsignalen (F_{H}) liefert, dadurch gekennzeichnet, dass jede der n Phasen (Phj) auf eine gleiche Anzahl von m programmierbaren Bruchwert-Teilern (5, 6, 7) geleitet wird, deren jeweilige Ausgänge (Phⱼ/Kᵢ, SUP(Qᵢ/n), SUP(2Qᵢ/n), ... , SUP((n-1)Qᵢ/n)) zu m Phasenabweichungskompensatoren (8, 9, 10) geleitet werden, die jeweils ausgehend von den n Phasen (Ph₁, ..., Phⱼ, ..., Phₙ), ein Taktsignal (CLK₁, ..., CLKᵢ, ..., CLKₘ) liefern, das auf die besagte Referenzfrequenz (F_{ref}) synchronisiert ist.

2. Frequenzsynthetisierer nach Anspruch 1, dadurch gekennzeichnet, dass jeder Bruchwert-Teiler (5, 6, 7) einen programmierbaren numerischen Teiler (30) aufweist, der ein Ausgangssignal (Phⱼ/Kᵢ) mit einer Frequenz liefert, die modulo dem Nenner (Qᵢ) des Betrages (Kᵢ₎ der BruchwertTeilung der schnellen Frequenz (F_{H}) geteilt durch den Bruchwertbetrag (Kᵢ) entspricht, und einen programmierbaren Zwischenspeicher (31) aufweist, der n-1 Signale (SUP(Qᵢ/n), SUP(2Qᵢ/n), ..., SUP((n-1)Qᵢ/n)) liefert, die die Lage einer jeden Anstiegsflanke des Ausgangssignales (Phⱼ/Kᵢ) des numerischen Teilers (30) liefern im Hinblick auf den Quotienten, durch die Zahl n von Phasen (Phⱼ), des Nenners (Qᵢ) des genannten Bruchwertbetrages (Kᵢ).

3. Frequenzsynthetisierer nach Anspruch 2, dadurch gekennzeichnet, dass der Zwischenspeicher (31) den numerischen Teiler (30) zwischen einem Funktionsmodus, in dem er die schnelle Frequenz (F_{H}) durch den ganzzahligen Teil (Iᵢ) des Bruchwertbetrages (Kᵢ) teilt, und einem Funktionsmodus konfiguriert, in dem er die schnelle Frequenz (F_{H}) durch den um eine Einheit erhöhten ganzzahligen Teil (Iᵢ) teilt, wobei der Zwischenspeicher (31) durch das Signal (Phⱼ/Kᵢ) am Ausgang des numerischen Teilers (30) synchronisiert wird.

4. Frequenzsynthetisierer nach Anspruch 3, dadurch gekennzeichnet, dass der ganzzahlige Teil (Iᵢ) des Bruchwertbetrages (Kᵢ) mindestens 3 ist.

5. Frequenzsynthetisierer nach Anspruch 3 oder 4, dadurch gekennzeichnet, dass der numerische Teiler (30) durch den genannten ganzzahligen Teil (Iᵢ), vermindert um eine Einheit, programmiert ist und die Phase (Phⱼ) empfängt, die von demjenigen Bruchwertteiler (5, 6, 7) verwendet wird, mit dem er integriert ist, wobei der Zwischenspeicher (31) durch den Nenner (Qᵢ) des Bruchwertbetrages (Kᵢ) und auch durch den Rest (Rᵢ) der Division des Zählers (Pᵢ) des Bruchwertbetrages (Kᵢ) durch den Nenner (Qᵢ) programmiert ist.

6. Frequenzsynthetisierer nach einem der Ansprüche 2 bis 5, dadurch gekennzeichnet, dass jeder Phasenabweichungskompensator (8, 9, 10) einen Schalter mit n Eingängen (S₆₀, S₆₁, S₆₂₎ und einem Ausgang (CLKᵢ) aufweist, der durch n Signale (S₆₆, S₆₇, S₆₈) gesteuert wird, die durch n D-Flip-Flops (66, 67, 68) geliefert werden, welche durch das Ausgangssignal (Phⱼ/Kᵢ) desjenigen numerischen Teilers (30) gesteuert werden, dem der Kompensator (8, 9, 10) zugeordnet ist, wobei jedes Steuer-Flip-Flop (66, 67, 68) ein Ausgangssignal eines logischen Decoders (69) empfängt, der an seinem Eingang die genannten n-1 Signale (SUP(Qᵢ/n), SUP(2Qᵢ/n), ..., SUP((n-1)Qᵢ/n)) empfängt, die von dem Zwischenspeicher (31) geliefert werden.

7. Frequenzsynthetisierer nach Anspruch 6, dadurch gekennzeichnet, dass jeder Eingang des Schalters mit einem Ausgang eines D-Flip-Flops (60, 61, 62) zur Phasenverschiebung verbunden ist, wobei ein erstes Phasenverschiebungs-Flip-Flop (60) durch die Phase (Phⱼ) der schnellen Frequenz (F_{H}) gesteuert ist, die durch den Bruchwert-Teiler (5, 6, 7) verwendet wird, der dem entsprechenden Kompensator (8, 9, 10) zugeordnet ist, und die übrigen Phasenverschiebungs-Flip-Flops (61, 62) jeweils durch eine andere Phase der schnellen Frequenz (F_{H}) gesteuert werden.

8. Frequenzsynthetisierer nach Anspruch 6 oder 7, dadurch gekennzeichnet, dass alle in ihm enthaltenen Phasenabweichungskondensatoron und alle in ihm enthaltenen Bruchwert-Teiler (5, 6, 7) eine identische Ausbildung haben, wobei zwei Stufen (2, 3, 4) des Synthetisierers sich durch die Phase (Phⱼ) unterscheiden, die das erste Phasenverschiebungs-Flip-Flop (60) ihres Phasenabweichungskompensators (8, 9, 10) empfängt und/oder durch die Werte (Qᵢ, Rᵢ, I₁-1) die zum Programmieren ihres Bruchwert-Teilers (5, 6, 7) eingeführt werden.

9. Frequenzsynthetisierer nach einem der Ansprüche 1 bis 8, dadurch gekennzeichnet, dass der Oszillator (20) der Phasenverriegelungsschaltung (1) drei Phasen (Ph₁ Ph₂,Ph₃) der schnellen Frequenz (F_{H}) liefert.
